(19) Europäisches Patentamt
European Patent Office
Office européen des brevets

(11) Veröffentlichungsnummer: **0 062 700**
**B1**

(12) **EUROPÄISCHE PATENTSCHRIFT**

(45) Veröffentlichungstag der Patentschrift: **22.02.84**

(51) Int. Cl.$^3$: **H 03 F 1/30,** H 03 F 3/187

(21) Anmeldenummer: **81109135.4**

(22) Anmeldetag: **28.10.81**

(54) **Integrierbare Halbleiterschaltung mit einem gegengekoppelten, nichtinvertierenden Operationsverstärker.**

(30) Priorität: **07.04.81 DE 3114042**

(43) Veröffentlichungstag der Anmeldung: **20.10.82 Patentblatt 82/42**

(45) Bekanntmachung des Hinweises auf die Patenterteilung: **22.02.84 Patentblatt 84/8**

(84) Benannte Vertragsstaaten: **DE FR GB IT**

(56) Entgegenhaltungen:
**DE - A - 2 247 471**
**DE - A - 2 542 746**
**GB - A - 2 022 949**
**US - A - 3 898 576**
**US - A - 3 904 972**

**SIEMENS Datenbuch 1980/81, "Integrierte Schaltungen für die Unterhaltungselektronik"**

(73) Patentinhaber: **SIEMENS AKTIENGESELLSCHAFT, Berlin und München Wittelsbacherplatz 2, D-8000 München 2 (DE)**

(72) Erfinder: **Mündel, Gerald, Dipl.-Ing., Pienzenauerstrasse 14, D-8019 Glonn (DE)**
Erfinder: **Lenz, Michael, Ing. grad., Hanselmannstrasse 9, D-8000 München 40 (DE)**

**EP 0 062 700 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

# Integrierbare Halbleiterschaltung mit einem gegengekoppelten, nichtinvertierenden Operationsverstärker

Die Erfindung bezieht sich auf eine integrierbare Halbleiterschaltung mit einem gegengekoppelten, nicht invertierenden Operationsverstärker, bei dem der Signalausgang des Operationsverstärkers über einen Widerstand mit dem invertierenden Eingang desselben und letzterer über einen Widerstand mit einem Kondensator und dieser Kondensator mit dem Bezugspotential verbunden ist, derart, daß der Kondensator mit den beiden Widerständen einen zwischen dem Bezugspotential und dem Ausgang des Operationsverstärkers liegenden Spannungsteiler bilden, bei dem außerdem das dem Operationsverstärker zusammen mit dem Bezugspotential die Versorgungsspannung liefernde Betriebspotential nicht nur mit dem Versorgungseingang des Operationsverstärkers sondern auch über die Serienschaltung zweier Widerstände mit dem nichtinvertierenden Signaleingang des Operationsverstärkers verbunden ist, während ein Schaltungspunkt zwischen den beiden zuletzt genannten Widerständen durch die Parallelschaltung eines weiteren Widerstandes mit einem weiteren Kondensator an das Bezugspotential gelegt ist.

Ein diese Merkmale aufweisender NF-Verstärker ist in »Siemens Datenbuch 1980/81« Integrierte Schaltungen für die Unterhaltungselektronik auf S. 556 und 557 dargestellt.

Nun tritt bei OP-Schaltungen der oben definierten Art leicht ein Überschwingen der Ausgangsspannung auf, da die Wahl der Zeitkonstanten bei mit Widerständen und Kondensatoren gegengekoppelten Verstärkern die Einstellung der Zeitkonstanten entscheidend dafür ist, ob nach dem Einschalten der Versorgungsspannung sich die Spannung am Ausgang des OP stabil oder labil verhält. Zu berücksichtigen ist dabei, daß der Innenwiderstand RG der den Signaleingang des OP steuernden Signalquelle N die Eingangs-Zeitkonstante zusammen mit der Ankoppelkapazität $C_e$ bestimmt.

Um das Überschwingen am Signalausgang A des Operationsverstärkers zu unterbinden, hat man für eine vorzusehende Außenbeschaltung der Verstärkerschaltung nur einen engbegrenzten erlaubten Bereich für den Innenwiderstand $R_G$ der den Verstärker steuernden Quelle und einen nur minimalen Wert für die Ankoppelkapazität $C_e$ zur Verfügung. Andernfalls hat man aufgrund des vorliegenden Standes der Technik nur noch die Möglichkeit, den Gegenkopplungszweig so auszuführen, daß keine Zeitkonstante auftritt, was den Nachteil mit sich bringt, daß die Offsetspannung mitverstärkt wird.

Es ist Aufgabe der Erfindung, eine Verstärkerschaltung der eingangs definierten Art so auszugestalten, daß das Problem des Überschwingens vermieden und dennoch die Vorteile einer Gegenkopplung mit Zeitkonstante erhalten bleiben.

Hierzu wird gemäß der Erfindung die eingangs definierte Verstärkerschaltung mit zwei Dioden und einer Hilfsgleichspannungsquelle derart versehen, daß der negative Pol der Hilfsgleichspannungsquelle mit dem Bezugspotential und der positive Pol mit den Anoden zweier Dioden verbunden ist, wobei die Kathode der einen Diode über den einen der beiden sich zwischen dem Signaleingang des Operationsverstärkers und dem Versorgungspotential befindenden Widerstände an diesen Signaleingang und die Kathode der anderen Diode an einen Schaltungspunkt zwischen den beiden Teilen des die Verbindung zwischen dem invertierenden Eingang des Operationsverstärkers und dem Bezugspotential bildenden Wechselspannungsteiler gelegt ist.

Eine Schaltung gemäß der Erfindung ist in Fig. 1 dargestellt, während Fig. 2 und Fig. 3 je ein Zeitdiagramm für das Verständnis der Wirkung der erfindungsgemäßen Schaltung bringen. Zu bemerken ist, daß der soeben genannte Wechselspannungsteiler durch die in der eingangs gebrachten Definition aufgeführte und die Verbindung zwischen dem invertierenden OP-Eingang und dem Bezugspotential bildende Serienschaltung eines Widerstands mit einem Kondensator gegeben ist.

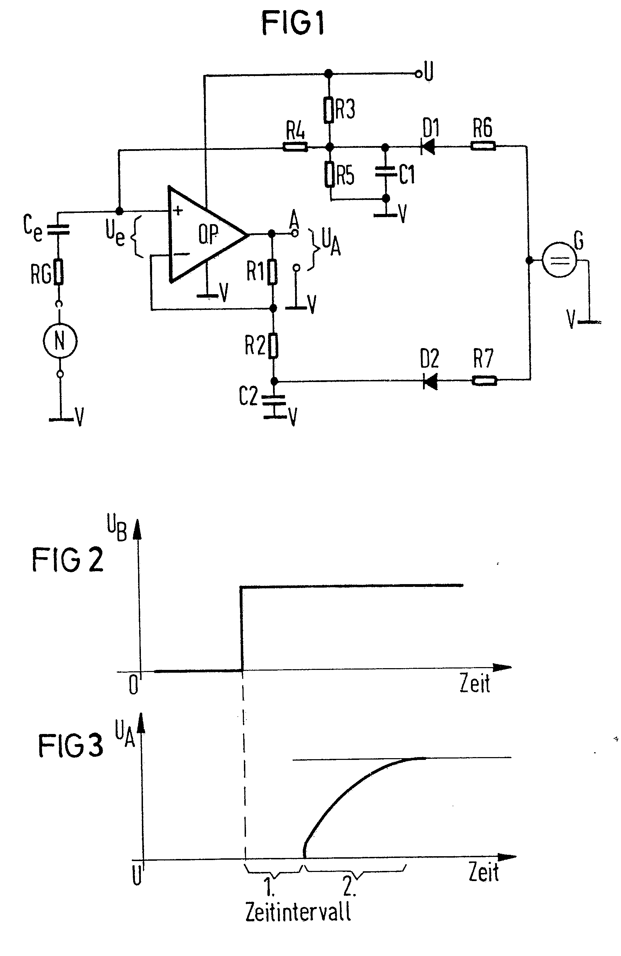

Bei dem in Fig. 1 dargestellten Schaltbild einer erfindungsgemäßen Verstärkerschaltung liegt der in bekannter Weise (vgl. z. B. Tietze und Schenk, »Halbleiter-Schaltungstechnik« [1980], S. 107–112) schaltungsmäßig ausgestaltete Operationsverstärker OP mit seiner einen Versorgungsklemme an Masse, also dem Bezugspotential V, und mit seiner anderen Versorgungsklemme an dem mit dem Bezugspotential V die Versorgungsspannung der Schaltung definierenden Betriebspotential U. Der nicht invertierende Eingang des Operationsverstärkers ist mit »+« bezeichnet und bildet die eine Eingangsklemme für das Eingangssignal, während der zweite Eingangsanschluß durch den mit dem Bezugspotential V zu beaufschlagenden Versorgungsanschluß gegeben ist.

Der Ausgang A des Operationsverstärkers OP bildet zugleich den Signalausgang der Schaltung. Er ist über einen Gegenkopplungswiderstand R1 mit dem invertierenden Eingang »–« des Operationsverstärkers und zudem über einen weiteren Widerstand R2 sowie einem mit dem Widerstand R2 in Serie liegenden Kondensator C2 mit der Klemme für das Bezugspotential V verbunden. Ersichtlich ist somit der invertierende Eingang »–« des Operationsverstärkers OP über einen Wechselstromspannungsteiler R2, C2 an das Bezugspotential V gelegt.

Ein Schaltungspunkt zwischen den beiden Bestandteilen dieses Wechselspannungsteilers R2, C2 ist mit der Kathode einer Diode D2 und deren Anode über den Widerstand R7 an den einen Pol einer Hilfsspannungsquelle G gelegt. Mit diesem Pol ist diese Hilfsspannungsquelle G,

welche eine noch zu definierende Gleichspannung $U_H$ liefert, außerdem noch über einen Widerstand R6 mit der Anode einer zweiten Diode D1 verbunden, während ihr anderer Pol an der mit dem Bezugspotential V zu beaufschlagenden Versorgungsklemme liegt.

Die Die Kathode der zuletzt genannten Diode D1 liegt sowohl über die Parallelschaltung des Kondensators C1 mit dem Widerstand R5 am Bezugspotential V als auch über einen Widerstand R3 an der das Betriebspotential U liefernden Versorgungsklemme als auch über einen Widerstand R4 am Signaleingang »+« des Operationsverstärkers OP und der das Bezugspotential führenden Anschlußklemme. Sie ist in anbetracht der nun folgenden Betrachtungen über die Wirkungsweise dieser Schaltung in Form einer Reihenschaltung aus der Kopplungskapazität $C_e$, aus dem Innenwiderstand der Signalquelle RG und der Signalspannung N dargestellt.

Wesentlich für die Wirkungsweise der gemäß der Erfindung vorgeschlagenen Verbesserung einer Verstärkerschaltung gemäß der eingangs gegebenen Definition ist, daß der Einschaltvorgang der Verstärkerschaltung in zwei Zeitintervalle aufgeteilt wird.

Im ersten Zeitintervall werden die die Zeitkonstante bestimmenden Kondensatoren C1 und C2 so rasch vorgeladen, daß der Ausgang A nicht überschwingen kann. Im zweiten Zeitintervall ist die aus den Widerständen R1 und R2 gegebene Gegenkopplungsschleife geschlossen und die zwischen der Ausgangsklemme A des OP und der das Bezugspotential führenden Versorgungsklemme liegende Ausgangsspannung $U_A$ nähert sich aperiodisch der Ausgangsruhespannung.

Im ersten Zeitintervall wird der Kondensator C1 über den Widerstand R6 und der Kondensator C2 über den Widerstand R7 rasch aufgeladen. Mit der Bedingung

$$(C_2 \cdot R7) < (C_1 \cdot R6)$$

wird die Eingangsspannung $U_e$ des Operationsverstärkers OP, also die Spannung zwischen dem nichtinvertierenden Eingang »+« und dem invertierenden Eingang »–« negativ. Dadurch bleibt der Verstärkungsausgang A nach Masse, also gegenüber dem Bezugspotential V, durchgeschaltet.

Weiter soll bei Bemessung des die Verbindung zwischen dem Versorgungspotential U und der Kathode der Diode D1 bildenden Widerstands $R_3$ insofern Rücksicht auf die Kapazität des diese Kathode mit dem Bezugspotential V verbindenden Kondensators C1 genommen werden, als man diese beiden Größen im Sinne der Beziehung

$$(R_3 \cdot C1) \gg (R6 \cdot C1)$$

d. h. also

$$R_3 \gg R_6$$

aufeinander abstimmt, d. h. den Widerstandswert von R3 wesentlich größer als den von R6 einstellt.

Durch die durch die von der Hilfsspannungsquelle G gelieferte Hilfs-Gleichspannung $U_H$ sowie durch die Betriebsspannung U bedingten Aufladevorgänge wird die Verstärkereingangsspannung $U_e$ am Ende des ersten Zeitintervalls gleich Null. Danach nähert sich die Ausgangsspannung $U_A$ aperiodisch der Ausgangsruhespannung.

In Fig. 2 ist das zeitliche Verhalten der durch die beiden Potentiale U und V definierten Versorgungsspannung $U_B$ und in Fig. 3 das aufgrund der erfindungsgemäßen Verbesserung der Schaltung erreichte Verhalten der Ausgangsspannung $U_A$ dargestellt. Die Abzisse stellt die zugehörigen Zeitwerte t im selben Maßstab dar.

Ist der Eingangswiderstand, also der Innenwiderstand $R_G$ der Signalquelle sehr groß, dann bringt die erfindungsgemäße Maßnahme den weiteren Vorteil mit sich, daß ein kleiner, d. h. weniger als 200 µF Kapazität aufweisender Koppelkondensator $C_e$ eingesetzt werden kann, während man sonst eine Eingangskoppelkapazität von wenigstens 200 µF benötigt. Durch die Verwendung der niedrigen Eingangskoppelkapazität $C_e$ erreicht man den Vorteil, daß das Einschaltverhalten der erfindungsgemäßen Schaltung praktisch unabhängig vom Innenwiderstand $R_G$ des Signalgenerators wird.

Der OP kann sowohl mit npn- als auch mit pnp-Transistoren aufgebaut werden.

**Patentansprüche**

1. Integrierbare Halbleiterschaltung mit einem gegengekoppelten, nicht invertierenden Operationsverstärker (OP), bei der der Signalausgang (A) des Operationsverstärkers über einen Widerstand (R1) mit dem invertierenden Eingang (–) desselben und letzteren über einen Widerstand (R2) mit einem Kondensator (C2) und dieser Kondensator mit dem Bezugspotential (V) verbunden ist, derart, daß der Kondensator (C2) mit den beiden Widerständen (R1, R2) einen zwischen dem Bezugspotential (V) und dem Ausgang (A) des Operationsverstärkers (OP) liegenden Spannungsteiler bildet, bei der außerdem das dem Operationsverstärker (OP) zusammen mit dem Bezugspotential (V) die Versorgungsspannung liefernde Betriebspotential (U) nicht nur mit dem Versorgungseingang des Operationsverstärkers (OP) sondern auch über die Serienschaltung zweier Widerstände (R3, R4) mit dem nichtinvertierenden Signaleingang (+) des Operationsverstärkers (OP) verbunden ist, während ein Schaltungspunkt zwischen den beiden zuletzt genannten Widerständen (R3, R4) durch die Parallelschaltung eines weiteren Widerstandes (R5) mit einem weiteren Kondensator (C1) an das Bezugspotential (V) gelegt ist, gekennzeichnet durch die Anwesenheit zweier Dioden (D1, D2) und einer Hilfsgleichspannungsquelle (G), derart, daß der eine Pol der Hilfsgleichspannungsquelle (G) mit dem Bezugspotential (V) und der andere Pol mit den Anoden der beiden Dioden (D1, D2) verbunden ist, wobei die Kathode der einen Diode (D1) über den einen (R6) der beiden sich zwischen dem nichtinvertierenden Signaleingang (+) des Operationsverstärkers (OP) und dem Versorgungspotential (U) befindenden Widerstände (R3, R4) an diesen Signaleingang (+) und die Kathode der anderen Diode (D2) an einen Schaltungspunkt zwischen den beiden Teilen (C2, R2) des die Verbindung zwischen dem invertierenden Eingang (−) des Operationsverstärkers (OP) und dem Bezugspotential bildenden Wechselspannungsteilers (C2, R2) gelegt ist.

2. Halbleiterschaltung nach Anspruch 1, dadurch gekennzeichnet, daß die beiden Dioden (D1, D2) durch je einen Widerstand (R6, R7) mit dem sie gemeinsam beaufschlagenden Pol der Hilfsgleichsspannungsquelle (G) verbunden sind.

3. Halbleiterschaltung nach Anspruch 2, dadurch gekennzeichnet, daß die beiden die Verbindung zwischen den beiden Dioden (D1, D2) und der Hilfsgleichspannungsquelle bildenden Widerstände (R6) und (R7) derart auf den mit der zugehörigen Diode kathodenseitig verbundenen Kondensator (C1 bzw. C2) abgestimmt sind, daß sie der Bedingung

$$(R6 \cdot C1) > (R7 \cdot C2)$$

genügen.

4. Halbleiterschaltung nach Anspruch 2 oder 3, dadurch gekennzeichnet, daß der zwischen der Versorgungsspannung und der Kathode der Diode (D1) liegende Widerstand merklich größer als der Widerstand zwischen der Anode dieser Diode (D1) und der Gleichspannungsquelle (G) ist.

## Claims

1. An integrable semiconductor circuit with a non-inverting operational amplifier (OP) provided with negative feedback, wherein the signal output (A) of the operational amplifier is connected via a resistor (R1) to the inverting input (−), the latter is connected via a resistor (R2) and a capacitor (C2) to the reference potential (V) in such manner that the capacitor (C2) and the two resistors (R1, R2) together form a voltage divider located between the reference potential (V) and the output (A) of the operational amplifier (OP), where the supply voltage for the operational amplifier (OP), of operating potential (U) with respect to the reference potential (V), is connected to the supply input of the operational amplifier (OP) and via the series arrangement of two resistors (R3, R4) to the non-inverting signal input (+) of the operational amplifier (OP), whilst a circuit point located between the two lastmentioned resistors (R3, R4) is connected via the parallel arrangement of a further resistor (R5) and a further capacitor (C1) to the reference potential (V), characterised by two diodes (D1, D2) and an auxiliary d.c. voltage source (G), the first pole of the auxiliary d.c. voltage source (G) being connected to the reference potential (V), and the other pole connected to the anodes of the two diodes (D1, D2), where the cathode of the first diode (D1) is connected to the signal input (+) via the first (R6) of the two resistors (R3, R4) located between this non-inverting signal input (+) of the operational amplifier (OP) and the supply potential (U), whereas the cathode of the other diode (D2) is connected to a circuit point located between the two components (C2, R2) of the a.c. voltage divider (C2, R2) which forms the connection between the inverting input (−) of the operational amplifier (OP) and the reference potential.

2. A semiconductor circuit as claimed in Claim 1, characterised in that each of the two diodes (D1, D2) are connected by a respective resistor (R6, R7) to that pole of the auxiliary d.c. voltage source (G) by which they are commonly fed.

3. A semiconductor circuit as claimed in Claim 2, characterised in that the two resistors (R6 and R7) which form the connection between the two diodes (D1, D2) and the auxiliary d. c. voltage source are adjusted with respect to the capacitor (C1, C2) connected to the associated diode on the cathode side to fulfil the condition

$$(R6 \cdot C1) > (R7 \cdot C2).$$

4. A semiconductor circuit as claimed in Claim 2 or 3, characterised in that the resistor located between the supply voltage and the cathode of the diode (D1) is significantly greater in magnitude than the resistor located between the anode of this diode (D1) and the d.c. voltage source (G).

## Revendications

1. Circuit à semiconducteurs intégré comportant un amplificateur opérationnel (OP) non inverseur, couple par contre-réaction, dans lequel la sortie (A) des signaux de l'amplificateur opérationnel est reliée par l'intermédiaire d'une résistance (R1) à l'entrée inverseuse (−) de cet amplificateur et cette entrée est reliée par l'intermédiaire d'une résistance (R2) à un condensateur (C2) et ce condensateur est relié au potentiel de référence (V), de telle sorte que le condensateur (C2) forme, avec les deux résistances (R1, R2), un diviseur de tension situé entre le potentiel de référence (V) et la sortie (A) de l'amplificateur opérationnel (OP), et dans lequel, en outre, le potentiel de service (U) fournissant en association avec le potential de

référence (V) la tension d'alimentation à l'amplificateur opérationnel (OP), est appliqué non seulement à l'entrée d'alimentation de l'amplificateur opérationnel (OP), mais également par l'intermédiaire du circuit série de deux résistances (R3, R4), à l'entrée non inverseuse des signaux (+) de l'amplificateur opérationnel (OP), tandis qu'un point de circuit situé entre les deux résistances (R3, R4) citées en dernier lieu est placées au potentiel de référence (V) par l'intermédiaire du circuit en parallèle formé d'une autre résistance (R5) et d'un autre condensateur (C1), caractérisé par la présence de deux diodes (D1, D2), et d'une source (G) de tension continue auxiliaire de telle sorte qu'une borne de la source (G) de tension continue auxiliaire est reliée au potentiel de référence (V) et que l'autre borne est reliée aux anodes des deux diodes (D1, D2), la cathode d'une diode (D1) étant reliée par l'intermédiaire de l'une (R6) des deux résistances (R3, R4) situées entre l'entrée non inverseuse des signaux (+) de l'amplificateur opérationnel (OP) et le potentiel d'alimentation (U), à cette entrée (+) des signaux et la cathode de l'autre diode (D2) étant reliée à un point du circuit situé entre les deux parties (C2, R2) du diviseur de tension alternative (C2, R2) constituant la liaison entre l'entrée inverseuse (−) de l'amplificateur opérationnel (OP) et le potentiel de référence.

2. Circuit à semiconducteurs suivant la revendication 1, caractérisé par le fait que les deux diodes (D1, D2) sont reliées par des résistances respectives (R6, R7) a la borne, qui les charge en commun, de la source (G) de tension continue auxiliaire.

3. Circuit à semiconducteurs suivant la revendication 2, caractérisé en ce que les deux résistances (R6) et (R7), constituant la liaison entre les deux diodes (D1, D2) et la source de tension continue auxiliaire, sont réglées sur le condensateur (C1 ou C2) relié, du côté de la cathode, à la diode associée, de telle sorte qu'elles satisfont la relation

$$(R6 \cdot C1) > (R7 \cdot C2).$$

4. Circuit à semiconducteurs suivant la revendication 2 ou 3, caractérisé par le fait que la résistance située entre la tension d'alimentation et la cathode de la diode (D1) est nettement supérieure à la résistance située entre l'anode de cette diode (D1) et la source de tension continue (G).

FIG 1

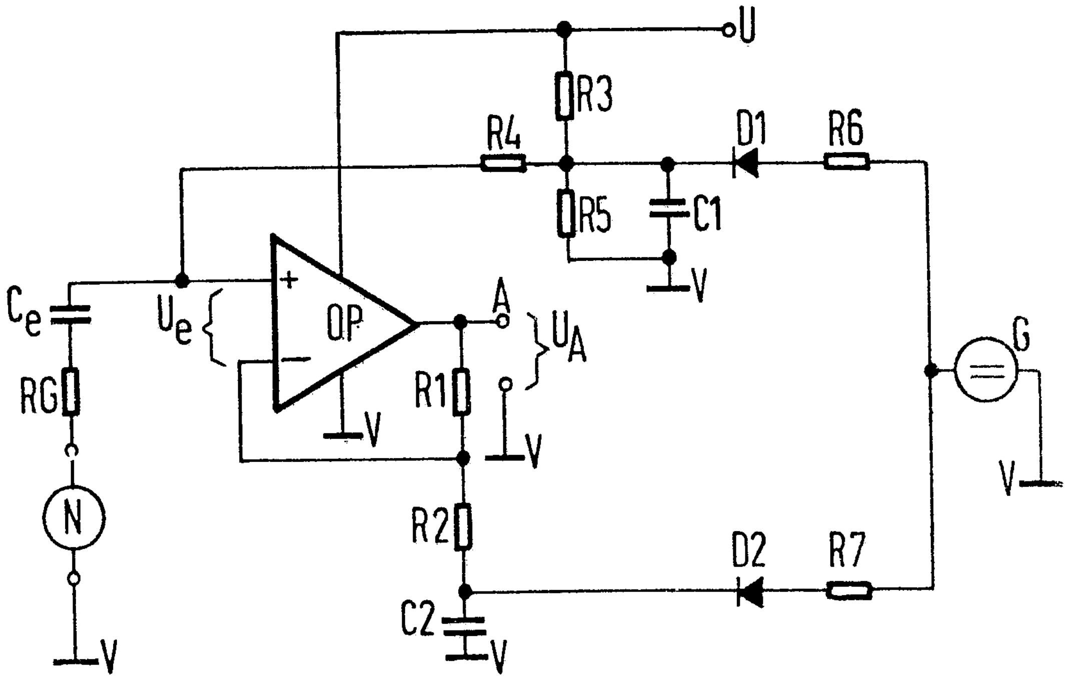


FIG 2

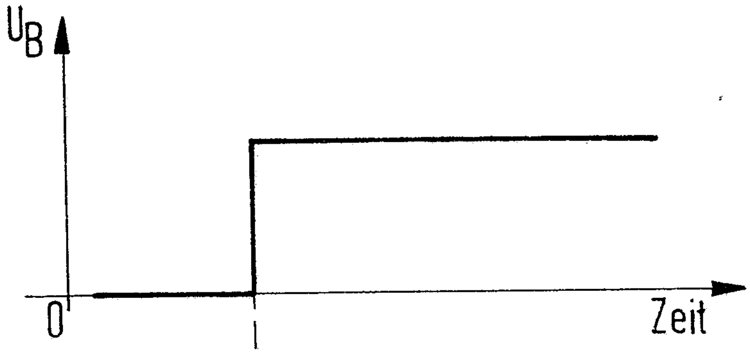


FIG 3